**Europäisches Patentamt**

(19) **European Patent Office**

**Office européen des brevets**

(11) Numéro de publication: **0 251 878**
**B1**

(12) **FASCICULE DE BREVET EUROPEEN**

(45) Date de publication du fascicule du brevet:
22.08.90

(21) Numéro de dépôt: 87401415.2

(22) Date de dépôt: 22.06.87

(51) Int. Cl.⁵: **B29C 45/44,** B29C 45/26,
H05K 5/00

(54) Procédé et dispositif de moulage de boîtiers, de coffrets ou armoires, et boîtier obtenu.

(30) Priorité: 25.06.86 FR 8609202

(43) Date de publication de la demande:
07.01.88 Bulletin 88/1

(45) Mention de la délivrance du brevet:
22.08.90 Bulletin 90/34

(84) Etats contractants désignés:
AT BE CH DE ES GB GR IT LI LU NL SE

(56) Documents cités:
EP-A- 0 088 224
BE-A- 496 908
DE-B- 1 244 379
DE-U- 6 806 262
FR-A- 1 545 004
FR-A- 2 117 899
US-A- 3 905 740

TECHNICAL DIGEST, no.64, octobre 1981, page 1, New York, US; R.J. APPLEGATE et al.: "An electrical component package"

(73) Titulaire: SAREL APPAREILLAGE ELECTRIQUE Société anonyme, Route de Phalsbourg, F-67260 Sarre Union(FR)
Titulaire: Société dite VYNCKIER (société de droit belge), Nieuwevaart 51, B-9000 Gent(BE)

(72) Inventeur: Buchy, Bernard, Lotissement Waldmat, F-67320 Schoenbourg(FR)
Inventeur: Munsch, Richard, 2, rue des Jacinthes, F-67260 Sarre Union(FR)
Inventeur: Henry, Jacques, 29, rue du Brotsch, F-67700 Otterswiller(FR)
Inventeur: Gasthuys, Paul, Kantstraat 20, B-9910 Gent/Mariakerke(BE)
Inventeur: Van Yper, Guy, Steenoven 23, B-9761 Zingem/Ouwegen(BE)

(74) Mandataire: Lerner, François, 5, rue Jules Lefèbvre, F-75009 Paris(FR)

ACTORUM AG

## Description

L'invention concerne, notamment, un procédé de fabrication par moulage de boîtiers de coffrets ou armoires.

De façon générale, selon ce procédé:

– après avoir moulé en une seule pièce le boîtier entre l'empreinte en creux d'une matrice extérieure et un poinçon intérieur de moule, ledit poinçon étant formé de plusieurs blocs comprenant un noyau central entouré de plusieurs pavés latéraux,

– et après avoir ouvert ledit moule en écartant l'un de l'autre la matrice et le poinçon,

– on sépare ledit noyau et lesdits pavés et on dégage ces mêmes pavés des parois du boîtier en les rétractant dans un mouvement relatif de rapprochement dirigé suivant des axes pyramidaux qui vont en convergeant dans le sens du dégagement des pavés.

Un tel procédé est divulgué notamment au document DE-A 1 244 379. Mais du fait de l'orientation du mouvement de rétraction des pavés suivant des axes pyramidaux, on tend à créer des efforts de pression tels que les boîtiers obtenus risquent de présenter des points de faiblesse au voisinage de leurs angles, c'est-à-dire en regard des angles extérieurs du poinçon.

Pour éviter ces inconvénients et en particulier contenir et guider les efforts de moulage dans les coins du moule et faciliter les opérations de démoulage du boîtier, le procédé de l'invention se caractérise en ce que l'on prévoit:

– de former les pavés de façon à laisser libres lesdits coins du moule, et

– de prolonger le noyau de poinçon vers cesdits coins de sorte à ménager des redans d'angles entre lesquels pourront venir se loger lesdits pavés.

De cette façon, on simplifie les opérations de démoulage du boîtier et on limite le nombre de pièces mobiles nécessaires au démoulage.

L'invention concerne également un dispositif particulièrement adapté pour la mise en œuvre du procédé que l'on vient de présenter.

Ce dispositif se caractérise notamment en ce que le poinçon comprend au moins deux pavés latéraux disposés face à face et logés, pendant l'opération de moulage, vers l'intérieur du noyau de poinçon, entre des redans d'angles du noyau qui prolongent latéralement ce dernier vers les coins du moule.

Avantageusement, les pavés sont formés en "T" avec leur hampe dirigée sensiblement vers la partie centrale du noyau du poinçon.

De cette façon, on évite la création d'angles aigus vers les coins du moule et donc l'apparition de points de faiblesse.

L'invention concerne enfin un boîtier de coffrets ou armoires réalisé au moyen du dispositif susmentionné et/ou grâce au procédé de l'invention.

Ce boîtier est du type général comprenant:

– un volume interne prévu notamment pour le logement d'équipements électriques et pourvu d'un fond dans les angles duquel sont ménagées des chambres, lesquelles sont limitées par des parois intérieures les séparant du volume interne du boîtier et par des parois extérieures en vis-à-vis, ces chambres étant elles-mêmes équipées d'un fond,

– et des moyens de fixation pour lier le boîtier à un support.

Un tel boîtier est divulgué notamment au document FR-A 2 117 899.

Mais sur ce boîtier les moyens de fixation sont prévus pour être disposés à l'intérieur du volume interne du boîtier, c'est-à-dire dans la partie réservée aux équipements.

Or une telle disposition risque de nuire à l'isolation de ce volume et les équipements peuvent en pâtir, en particulier s'il s'agit d'équipements électroniques ou électriques.

Pour éviter en particulier ces inconvénients le boîtier de l'invention se caractérise en ce que le fond des chambres et celui du volume interne du boîtier sont formés d'un même côté, de telle sorte que les chambres s'ouvrent sur l'extérieur du même côté que ledit volume interne, et en ce que les moyens de fixation du boîtier sur son support sont prévus dans les chambres, permettant ainsi de déporter ces moyens en dehors du volume interne du boîtier.

De cette façon, on réalise un boîtier moulé monocoque à double isolation.

Avantageusement, le boîtier comporte une porte qui vient recouvrir son bord d'ouverture.

On obtient alors un coffret dont le boîtier peut être fixé sur son support de réception sans que pour autant on altère son isolation.

L'invention et sa mise en œuvre apparaîtront plus clairement de la description qui va suivre faite en référence aux dessins d'accompagnement dans lesquels:

– les figures 1, 2, 4 et 5 illustrent, en coupe longitudinale, et de façon schématique les différentes étapes de démoulage du coffret, conformément à la présente invention, ainsi que le dispositif prévu à cet effet

– la figure 3 montre une vue en coupe, selon la ligne III–III de la figure 2, du moule et du boîtier moulé, les pavés étant en position de moulage;

– la figure 6 illustre une vue en coupe, selon la ligne VI–VI de la figure 5, du moule et du boîtier moulé, les pavés du poinçon étant alors en position de démoulage, c'est-à-dire écartés des parois du boîtier;

– la figure 7 et une vue agrandie d'un détail de la figure 5;

– la figure 8 est une vue schématique en perspective du coffret de l'invention;

– la figure 9 est une vue suivant la flèche IX de la figure 8 et en coupe longitudinale d'une glissière du boîtier; et

– la figure 10 est une vue en perspective schématique du moule du dispositif de l'invention.

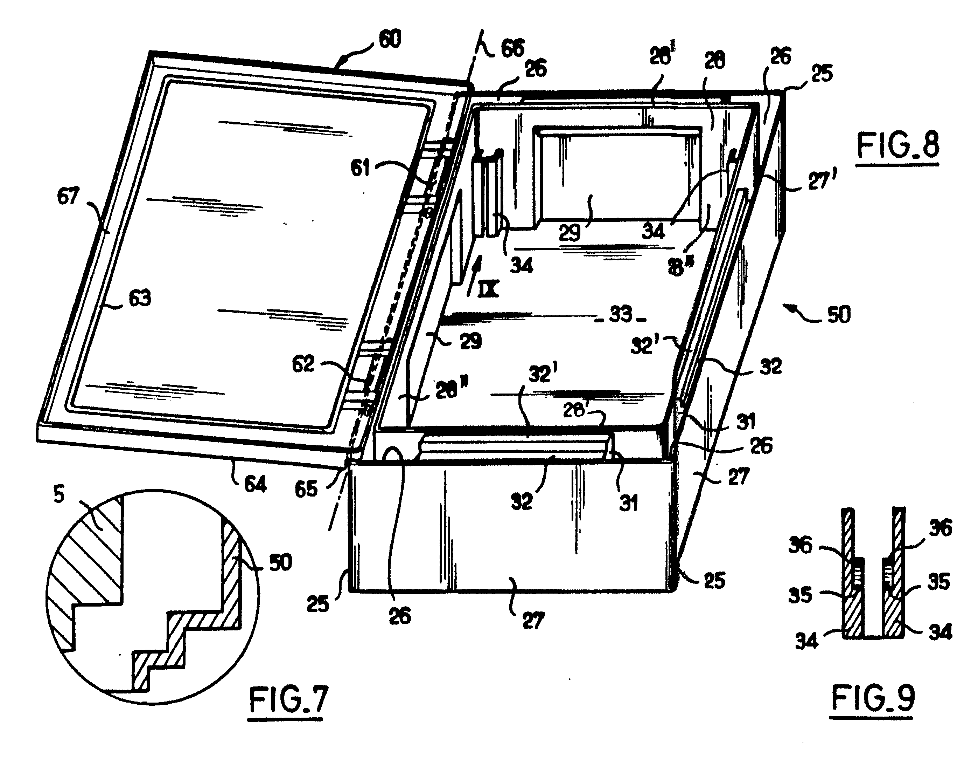

On va, tout d'abord, décrire le dispositif de l'invention permettant, en mettant en oeuvre un procédé particulier sur lequel on reviendra, de fabriquer un boîtier de coffret ou armoire du type de celui illustré figure 8, et qui sera décrit ultérieurement.

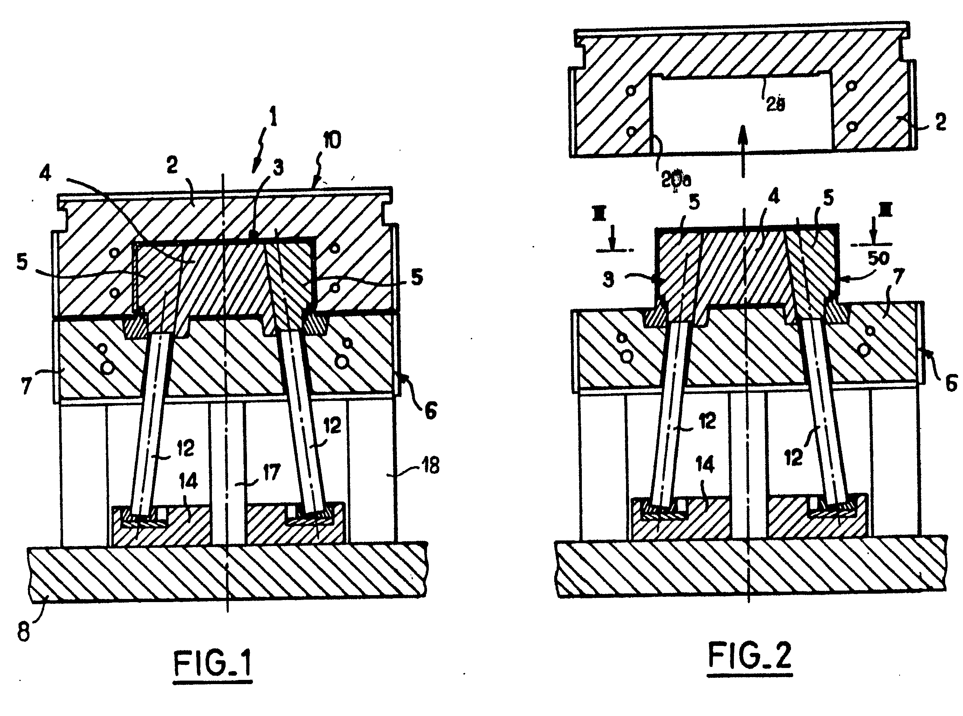

Aussi, en se reportant d'abord figure 1, on voit illustré un dispositif, repéré dans son ensemble 1, du type moule à compression.

Le dispositif 1 comprend un bâti de moule 6 sous-jacent et un moule 10 comprenant une matrice extérieure 2 et un poinçon intérieur 3, entre lesquels peut être moulé le boîtier, la matrice comprenant une empreinte en creux 2a de façon à venir recouvrir le poinçon 3 au cours de l'opération de moulage, ladite empreinte correspondant, comme on le comprend, à la forme extérieure de l'objet à mouler.

Le poinçon intérieur 3 est constitué de plusieurs blocs comprenant, notamment, un noyau central de poinçon 4 entouré de plusieurs pavés périphériques latéraux 5 venant sensiblement de niveau en position de moulage.

Le noyau 4 est supporté par un porte-poinçon 7 disposé vers la partie supérieure du bâti 6 du moule dont la partie inférieure, ou base est formée par un plateau 8 généralement appelé "plateau de montage" et qui est relié au bâti par des montants latéraux 18 verticaux.

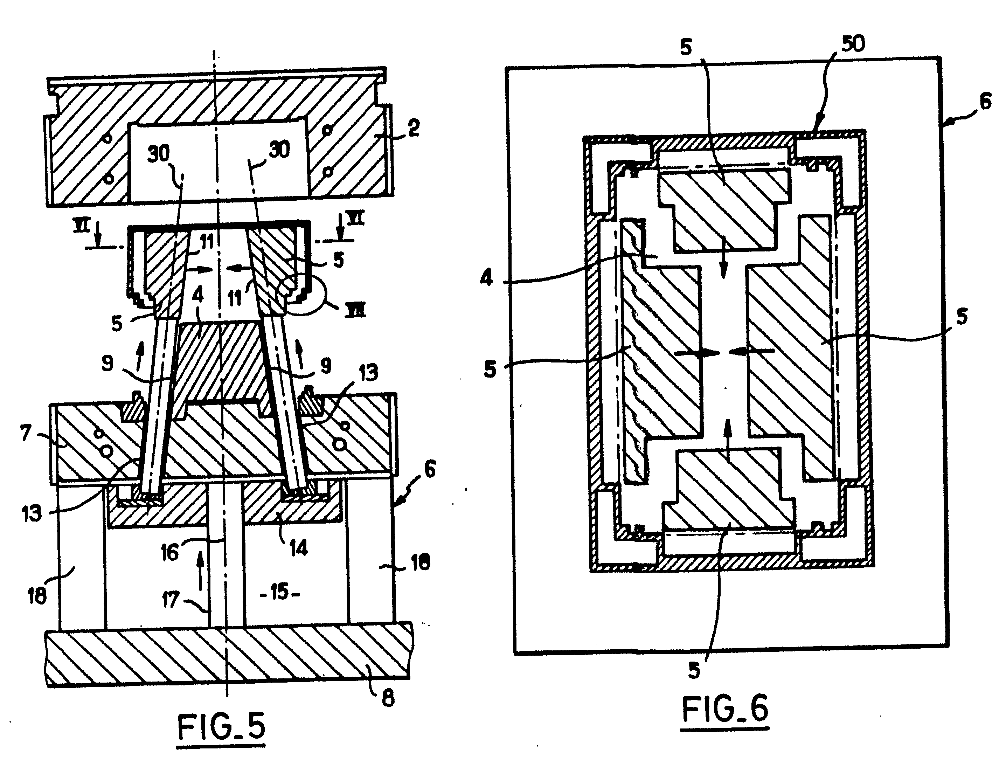

Comme il apparaît plus clairement de la figure 5, les parois latérales en regard du noyau de poinçon 4 et de chacun des pavés 5 ont la forme de rampes complémentaires, respectivement 9 et 11, inclinées suivant des axes pyramidaux 30.

Avantageusement, les rampes 11 des pavés se prolongent, vers le bâti 6, par des tiges de guidage 12 qui épousent les rampes 9 du noyau 4 et s'étendent dans le bâti 6 à travers des orifices 13 de guidage à coulissement formés dans le porte-poinçon 7. Les tiges de guidage 12 sont montés sur une plaque d'éjection 14, sensiblement horizontale logée vers l'intérieur du bâti, dans une chambre 15 qui peut être ouverte sur l'extérieur et qui est limitée par les montants 18.

La plaque d'éjection 14 est mobile en translation suivant un axe 16 sensiblement vertical médian aux axes pyramidaux 30. A cet effet, on prévoit, notamment, que la plaque 14 peut coulisser, à l'intérieur de la chambre 15 entre les montants de côté 18 du bâti, le long d'un pied central 17 qui s'étend dans l'axe 16 entre le porte poinçon 7 et le plateau de montage 8.

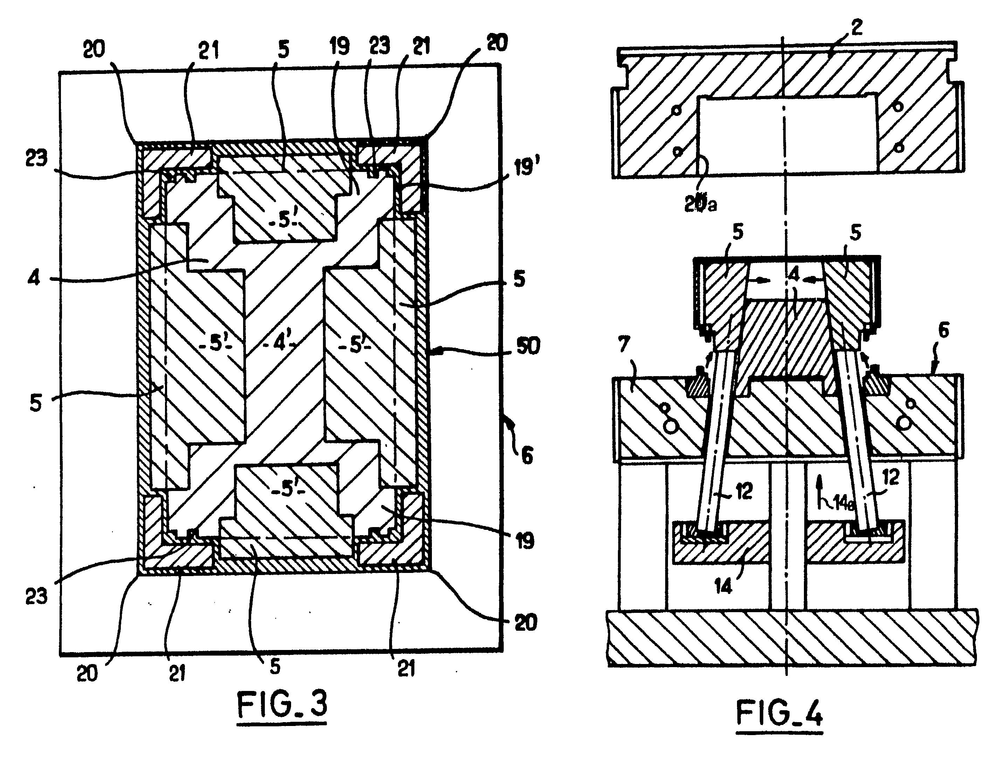

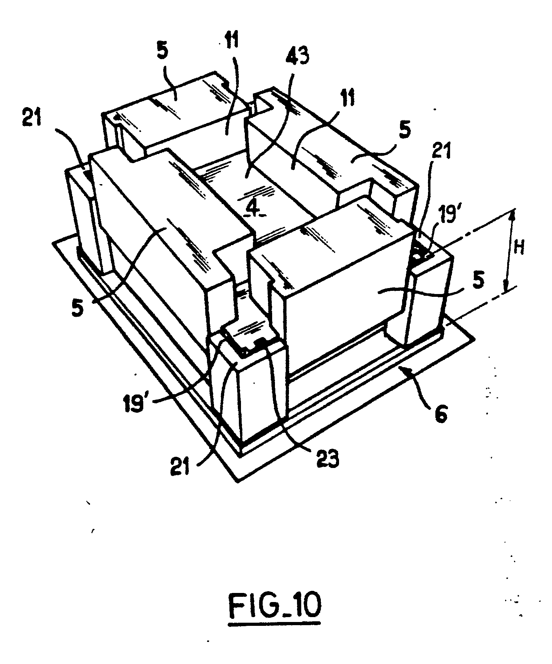

En se reportant maintenant plus particulièrement aux figures 3 et 10, on notera que le poinçon 3, à forme générale de parallélépipède rectangle, comprend au moins deux pavés latéraux 5 disposés en opposition et logés, notamment pendant l'opération de moulage du boîtier, vers l'intérieur du noyau de poinçon 4 entre des redans 19 du noyau qui prolongent, latéralement et dans un même plan de surface, ce dernier vers les coins extérieurs 20 ou angles du poinçon.

On prévoit avantageusement, tel qu'illustré, quatre pavés disposés deux à deux en opposition, par rapport à la partie centrale 4' du noyau 4. Avantageusement, et tel qu'illustré, les pavés 5 auront en section la forme d'un "T" posé à plat, avec leur hampe 5' de "T" dirigée sensiblement vers la partie centrale 4' du noyau 4.

Toujours sur les figures 3 et 10, on remarque des pieds d'angles 21 qui ont en section la forme d'une équerre et qui s'étendent le long de la hauteur H du noyau, en regard, légèrement écartés des redans 19, avec leur ouverture d'équerre dirigée vers les parois latérales (19') en regard de ces redans dont ils épousent sensiblement le contour.

Ces pieds 21 sont liés mécaniquement au noyau 4 et viennent sensiblement de niveau avec sa face de sommet 43 sensiblement plane.

Avantageusement, le noyau 4 comporte également, vers chacun de ses coins 20, des échancrures latérales verticales 23 . En pratique, ces échancrures 23 se présenteront sous la forme d'une double rainure et seront ménagées, telles qu'illustrées figures 3 et 10, deux à deux en vis-à-vis le long de deux parois latérales 19' opposées des redans 19, en regard d'une partie des pieds 21 en équerre, et ce par exemple sur la moitié de la hauteur de cette paroi, à partir de la face de sommet 43 du noyau.

On notera que les pieds en équerre 21 et les redans 19 assurent le guidage et le centrage du boîtier 50 par rapport à l'axe central 16 lors du mouvement relatif de séparation des pavés et du noyau de poinçon.

On va maintenant décrire en détail le procédé de l'invention qui permet de libérer le boîtier qui a été moulé en un mouvement unique d'extraction des pavés 5.

A cet effet, on va se reporter successivement aux figures 1, 2 et/ou 3, 4, 5 et/ou 6 illustrant les différentes étapes du procédé permettant de démouler et de libérer le boîtier de coffret.

On a tout d'abord représenté, figure 1, l'étape du procédé dans laquelle le boîtier 50 vient d'être moulé en une pièce monocoque entre la matrice extérieure 2 et le poinçon intérieur 3 en appui sur le porte-poinçon du moule. On notera que les pavés 5 sont alors en position de moulage, c'est-à-dire viennent de niveau avec la face de sommet 43 du noyau 4.

A l'issue de ce moulage, on ouvre le moule 10 en séparant, dans un mouvement relatif de translation, la matrice 2 du porte-poinçon 7 et en l'écartant de la paroi en regard du boîtier 50, toujours prisonnier du poinçon 3 par les pavés 5 qui sont bloqués en appui contre la paroi périphérique intérieure dudit boîtier par le noyau (figure 2).

On a illustré, figure 3, par des traits mixtes la limite intérieure de la paroi du boîtier 50 au niveau des pavés 5. On voit ainsi que la paroi du boîtier déborde, en cours de moulage et en début d'opération de démoulage, en partie sur les pavés 5, empêchant le dégagement et la libération du boîtier.

Pendant l'ouverture du moule, et comme on le comprend, la plaque d'éjection 14 est en position basse de moulage, maintenant en contact les rampes latérales inclinées 9 et 11, respectivement du noyau 4 et des pavés 5 (figure 2).

Dans l'étape suivante de démoulage, illustrée figure 4, on maintient la matrice 2 suffisamment écartée, et on commence à faire coulisser la plaque d'éjection 14, par exemple à l'aide de vérins (non représentés) le long du pied central 17 et selon l'axe vertical 16, dans le sens ascendant indiqué par la flèche 14a. Ce mouvement de translation de la plaque 14 provoque, dans un mouvement simultané et conjugué, le déplacement relatif du noyau 4 et des pavés 5, et le dégagement de ces mêmes pavés par rapport à la paroi en regard du boîtier 50, dans un mouvement de rapprochement. En effet, poussés par la plaque d'éjection 14 qui entraîne dans son mouvement les tiges 12, les pavés 5 glissent ou coulissent par rapport au noyau 4 suivant les axes pyramidaux 30 qui vont en se rapprochant ou qui convergent dans le sens du dégagement de ces pavés.

Sur cette figure 4, on a indiqué par des flèches les sens de déplacement relatifs non seulement de la plaque d'éjection 14, mais également des tiges de guidage 12 et des pavés 5, lesquels sens correspondent aux opérations de démoulage du boîtier.

Comme on le comprend, les sens doivent être inversés pour toute nouvelle opération de moulage d'un boîtier.

Figure 5, on a illustré l'étape finale de démoulage et de libération du boîtier.

Sur cette figure, on voit que la plaque d'éjection 14 est en position haute et que les pavés 5 et le noyau 4 ont suffisamment coulissé l'un par rapport à l'autre suivant les axes pyramidaux 30 pour que lesdits pavés 5 soient complètement dégagés de leur appui contre la paroi en regard du boîtier 50, permettant ainsi la libération et la récupération de ce dernier.

Si l'on se reporte à la figure 7, on remarque que l'on a illustré, dans une vue agrandie, l'espace intermédiaire existant entre les pavés 5 et la paroi du boîtier 50 à l'issue des opérations conjuguées de démoulage.

De même, on a illustré figure 6 la position finale rétractée des pavés 5 à l'issue des opérations de démoulage, montrant que les différents pavés sont suffisamment écartés de la paroi en regard du boîtier, dont on a illustré le débordement intérieur maximal par un trait mixte, pour en permettre la manutention aisée.

Il apparaît donc que le procédé de l'invention permet de rétracter quatre pavés en un seul mouvement d'extraction, ce qui entraîne une diminution du nombre de pièces mobiles nécessaires et donc une réduction des coûts de fabrication, ainsi qu'une amélioration de la fiabilité du dispositif.

Comme il a déjà été noté, les différents mouvements consécutifs à l'opération de démoulage, sont relatifs. Cependant, on prévoit, de préférence, de maintenir fixe le noyau 4 de poinçon en appui sur le porte poinçon 7 du bâti 6 et de faire coulisser les pavés 5 par rapport au noyau.

On notera que les pavés 5 ayant été formés, selon l'invention de façon à laisser libres les coins 20 du moule vers lesquels se prolonge le noyau 4 de poinçon, on peut contenir et guider les efforts de pression de moulage dans cesdits coins, tout en facilitant les opérations de démoulage du boîtier.

En outre, les pieds 21 de coins formés en équerre étant écartés légèrement à la fois par rapport aux parois latérales 20a de l'empreinte intérieure de la matrice 2 (figure 2) et aux parois 19' en regard du poinçon 3, on va pouvoir réaliser un boîtier comprenant, dans ses angles, une double paroi d'isolation.

Si l'on se reporte maintenant à la figure 8, on voit illustré un tel boîtier repéré dans son ensemble 50 que l'on a pu dégager du dispositif de l'invention en fin de démoulage.

Tel qu'illustré, le boîtier 50 qui a une forme générale parallélépipédique rectangle comprend, en particulier, vers ses angles extérieurs 25, des chambres ouvertes ou évidement 26 ayant en section la forme d'une équerre à ouverture dirigée vers le centre du boîtier. Les chambres sont ménagées après moulage entre des parois latérales périphériques extérieure 27 et intérieure 28 formées en regard et qui s'étendent du fond 33 du boîtier.

Avantageusement, ces chambres 26 s'étendent de ce même fond 33 jusqu'à la bordure libre périphérique 27' de la paroi extérieure 27. En effet, la hauteur de la paroi extérieure 27 étant, de préférence, légèrement inférieure à celle de la paroi intérieure 28, le volume de la chambre 26 débouche à l'extérieur du boîtier au niveau de la bordure libre 27'.

Le boîtier 50 comprend, en outre, entre certaines au moins des chambres 26, des dégagements 29 formés en creux sur la face interne 28" de la paroi intérieure 28 de boîtier.

Les dégagements 29 s'étendent sensiblement sur la largeur des chambres 26, c'est-à-dire qu'ils comblent l'espace compris entre la paroi intérieure 28 et la paroi extérieure 27 et limitent latéralement, en 31, le volume des chambres. Ils constituent donc en quelque sorte des nervures de raidissement du boîtier.

On notera que ces dégagements 29 sont de préférence formés sur les quatre faces intérieures du boîtier et s'étendent sur la plus grande partie de la hauteur de la paroi intérieure 28, en présentant une forme en escalier à double marches 32, 32', au niveau de leur partie supérieure proche de la bordure d'ouverture du boîtier. Cette forme en escalier permet d'améliorer encore la rigi dité du boîtier.

Le boîtier de l'invention est avantageusement prévu avec une porte 60, montée à pivotement sur des charnières 61, 62, formées sur un bord de côté du boîtier. On notera que le long du côté du boîtier où se trouve fixée la porte 60, le dégagement 29 ne comportera pas deux marches (32, 32') mais une seule 32 formée sensiblement au niveau de la bordure 27' de la paroi extérieure 27.

Un joint d'étanchéité 63 est avantageusement prévu sur la face intérieure 67 de la porte de façon à être reçu en position de fermeture de cette dernière sensiblement au niveau de la bordure libre périphérique 28' de la paroi intérieure 28 du boîtier.

On peut également prévoir que ce joint 63 vienne prendre appui contre la marche extérieure supérieure 32' des dégagements 29 la plus proche de la bordure 28', de façon à être suffisamment comprimé pour assurer une isolation de la partie intérieure du boîtier limitée par le fond 33 et la paroi 28.

Comme on le comprend, la porte 60 vient, en position de fermeture, recouvrir entièrement l'ouverture du boîtier 50 en venant, par exemple, sensiblement en appui contre la bordure libre 27' de la paroi extérieure 27 du boîtier.

On notera que le boîtier de l'invention, par la prévision de ces chambres d'angles 26, est donc conçu à double isolation, sa fixation sur son support de réception (non représenté) pouvant être facilement effectué, notamment, au niveau du fond des chambres intermédiaires 26, au moyen d'orifices débouchant dans lesquels on peut, par exemple, introduire des vis de fixation, sans pour autant altérer l'isolation de la partie intérieure du boîtier limitée par la paroi 28 et le fond 33.

On notera également que, la porte 60 recouvrant l'ensemble du boîtier, on ne peut avoir accès auxdites vis de fixation sans ouvrir la porte, laquelle sera, de préférence, munie d'une serrure de sécurité.

Avantageusement, on prévoit, en outre, que la porte comprend sur sa face extérieure 64 un décrochement 65 formé en creux, sur la longueur de la porte, et sensiblement le long de l'axe 66 de charnière, de façon à permettre une ouverture à angle plat de cette porte.

Sur les figures 8 et 9, sont illustrés, et repérés en 34 des glissières intégrant des butées 35 et formées de moulage vers les coins du boîtier. De préférence, les glissières 34, au nombre de quatre, s'étendent sensiblement verticalement du fond 33 du boîtier sur la moitié de sa profondeur et sont formés de moulage deux à deux en regard sur la face interne 28" de la paroi intérieure 28.

Les glissières 34, que l'on prévoira, de préférence, vers chacun des coins du boîtier, pourront, notamment, recevoir des platines supports d'appareillage électrique ou autre, lesquelles platines viendront en appui contre les butées 35 où elles seront maintenues après avoir été guidées, par exemple, par des rampes 36.

On notera que les butées 35 seront, de préférence, positionnées pour permettre de fixer les platines dans le coffret à une même distance de la porte, quel que soit le type de coffret.

**Revendications**

1. - Procédé de fabrication de boîtiers de coffrets ou armoires par moulage du type dans lequel,
- après avoir moulé en une seule pièce ledit boîter (50) entre l'empreinte en creux (2a) d'une matrice extérieure (2) et un poinçon intérieur (3) de moule (10), ledit poinçon étant formé de plusieurs blocs comprenant un noyau central (4) entouré de plusieurs pavés (5) latéraux venant sensiblement de niveau en position de moulage, et
- après avoir ouvert ledit moule (10)
- on sépare ledit noyau (4) et lesdits pavés (5) dans un mouvement relatif de translation, puis,
- on dégage les pavés (5) des parois du boîtier (50) en les rétractant dans un mouvement de rapprochement, permettant ainsi de libérer le boîtier moulé ;
ledit procédé étant caractérisé en ce que afin de contenir et de guider les efforts de pression de moulage dans les coins(20)du moule et de faciliter les opérations de démoulage du boîtier, on prévoit :
- de former les pavés (5) de façon à laisser libres lesdits coins (20) du moule (10), et
- de prolonger le noyau (4) de poinçon vers cesdits coins de sorte à ménager des redans (19) d'angles entre lesquels pourront venir se loger lesdits pavés (5).

2. - Procédé selon la revendication 1, caractérisé en ce qu'on effectue simultanément, après ouverture du moule, lesdits mouvements de séparation entre le noyau (4) et les pavés (5) et de rapprochement desdits pavés entre eux, en déplaçant ces derniers suivant des axes pyramidaux (30) qui vont en convergeant dans le sens du dégagement des pavés.

3. - Procédé selon la revendication 1 ou la revendication 2, caractérisé en ce qu'on prévoit de ménager, dans lesdits coins (20) du moule, entre les parois latérales (20a) de l'empreinte de la matrice (2) et les parois latérales (19') en regard du noyau (4) de poinçon, des intérieur (3) constitué de plusieurs blocs comprenant un noyau central (4) de poinçon entouré de plusieurs pavés (5) latéraux, le noyau (4) de poinçon et chacun des pavés (5) présentant des parois latérales en vis-à-vis ayant la forme des rampes complémentaires (9, 11) inclinées suivant des axes pyramidaux (30), ledit dispositif étant caractérisé en ce que le poinçon (3) comprend au moins deux pavés latéraux (5) disposés face à face et logés, pendant l'opération de moulage, vers l'intérieur du noyau (4) de poinçon, entre les redans (19) d'angles du noyau qui prolongent latéralement ce dernier vers les coins (20) du moule.

4. Dispositif selon la revendication 3, caractérisé en ce que les pavés (5) se présentent sous la forme d'un "T" avec la hampe (5') du "T" dirigée sensiblement vers la partie centrale (4') du noyau (4) de poinçon.

5. Dispositif selon la revendication 3 ou la revendication 4, caractérisé en ce que le noyau (3) comprend quatre pavés latéraux se faisant face deux à deux.

6. Dispositif selon l'une des revendications 3 à 5 caractérisé en ce que la paroi latérale en forme de rampe (11) de chacun des pavés (5) se prolonge par une tige (12) de guidage qui épouse la forme de la rampe (9) en regard du noyau (4), lesdites tiges (12) pouvant s'étendre dans un bâti (6) de moule sous-jacent, à travers des orifices (13) de guidage en coulissement formés dans un porte-poinçon (7), lequel est disposé vers la partie supérieure du bâti (6) et supporte le noyau (4) pendant l'opération de moulage du boîtier (50).

7. Dispositif selon la revendication 6, caractérisé en ce que les tiges (12) de guidage sont montées sur une même plaque (14) d'éjection logée vers l'intérieur du bâti (6), sous ledit porte-poinçon (7), ladite plaque étant mobile en translation suivant un axe vertical (16) sensiblement médian auxdits axes pyramidaux (30).

8. Dispositif selon l'une quelconque des revendications 3 à 7, caractérisé en ce que des pieds (21) sont formés dans les coins du moule, en regard des redans (19) du noyau (4), chacun desdits pieds étant légèrement écarté des parois latérales (19') en regard du redan correspondant et se présentant sous la forme d'une équerre à ouverture dirigée vers ce redan.

9. Dispositif selon la revendication 8, caractérisé en ce que les pieds (21) sont liés mécaniquement au noyau (4) et viennent sensiblement de niveau avec lui.

10. Dispositif selon l'une quelconque des revendications 3 à 9, caractérisé en ce que des échancrures (23) qui se présentent chacune sous la forme d'une rainure double, sont ménagées deux à deux en vis à vis le long d'une partie au moins de la hauteur de deux parois latérales (19') opposées des redans (19).

11. Boîtier obtenu par la mise en œuvre du procédé selon la revendication 1 ou la revendication 2, ou au moyen du dispositif selon l'une quelconque des revendications 3 à 10, du type comprenant:

– un volume interne prévu notamment pour le logement d'équipements électriques et pourvu d'un fond (33) dans les angles duquel sont ménagées des chambres (26), lesquelles sont limitées par des parois intérieures (28) les séparant du volume interne du boîtier et par des parois extérieures (27) en vis-à-vis, ces chambres étant elles-mêmes équipées d'un fond,

– et des moyens de fixation pour lier le boîtier à un support, caractérisé en ce que le fond des chambres (26) et celui (33) du volume interne du boîtier sont formés d'un même côté, de telle sorte que les chambres (26) s'ouvrent sur l'extérieur du même côté que ledit volume interne, et en ce que les moyens de fixation du boîtier sur son support sont prévus dans les chambres (26), permettant ainsi de déporter ces moyens en dehors du volume interne du boîtier.

12. Boîtier selon la revendication 11 caractérisé en ce qu'il comporte une double enceinte définie par les parois latérales respectivement extérieures (27) et intérieures (28), ces dernières étant reliées entre-elles sur certains au moins des côtés du boîtier, entre deux chambres d'angle (26) sucessives, par des nervures (31) formant ponts de matière.

13. Boîtier selon la revendication 11 ou la revendication 12 caractérisé en ce que les ponts (31) de matière résultent de la déformation en creux (en 29) d'une partie des parois latérales intérieures (28) du boîtier.

14. Boîtier selon l'une quelconque des revendications 11 à 13 caractérisé en ce que les ponts (31) de matière présentent, à leur extrémité proche de la bordure libre du boîtier opposée au fond (33), une forme en escalier à double marche.

15. Boîtier selon l'une quelconque des revendications 11 à 14 caractérisé en ce qu'il comprend une porte (60) montée pivotante sur au moins une charnière (61, 62) prévue sur un bord de côté du boîtier, ladite porte (60) venant, en position de fermeture, recouvrir entièrement l'ouverture du boîtier, laquelle est limitée par les parois extérieures (27) de ce dernier, et comprenant un joint d'étanchéité (63) qui est reçu en position de fermeture de la porte sur la bordure libre en regard de chacun desdits ponts de matière (31), au contact des parois intérieures (28), de façon à assurer l'isolation de la partie interne du boîtier.

16. Boîtier selon la revendication 15 caractérisé en ce que la porte (60) comprend, sur sa face extérieure (64), un décrochement (65) formé sensiblement le long de l'axe (66) de la charnière, de façon à permettre une ouverture sensiblement à angle plat de la porte (60).

17. Boîtier selon l'une quelconque des revendications 11 à 16 caractérisé en ce qu'il comprend des glissières (34) intégrant des butées (35), lesdites glissières étant formées de moulage, deux à deux en regard, sur la face interne (28') des parois intérieures (28) et s'étendant à partir du fond (33) du boîtier, sensiblement sur la moitié de la profondeur de ce dernier.

18. Boîtier selon l'une quelconque des revendications 11 à 17 caratérisé en ce que la hauteur des parois intérieures (28) du boîtier est légèrement supérieure à la hauteur de ses parois extérieures (27).

**Patentansprüche**

1. Verfahren zur Herstellung von Gehäusen für Schaltkästen oder -schränke durch Formen bzw. Gießen derart, daß

– nach dem Formen bzw. Gießen des Gehäuses (50) in einem einzigen Stück zwischen der Hohlkontur bzw. Einprägung (2a) einer äußeren Matrize (2) und einem inneren Stempel (3) der Form (10), wobei dieser Stempel von mehreren Blöcken, umfassend einen von mehreren seitlichen Platten (5) umgebenden zentralen Kern (4), gebildet wird,

– und nach dem Öffnen der Gießform (10) durch Entfernen der Matrize (2) und des Stempels (3) voneinander,

– der Kern (4) und die Platten (5) getrennt und diese Platten (5) von den Seitenwänden des Gehäuses (50) durch Zurückziehen in einer relativen Annäherungsbewegung, die entlang pyramidaler Achsen (30) geführt wird, befreit werden, die die in Richtung des Herauslösens der Platten konvergieren, wobei das Verfahren dadurch gekennzeichnet ist, daß man, um die Druckkräfte des Gießvorganges in den Ecken (20) der Form aufzunehmen und zu führen und um das Entformen des Gehäuses zu vereinfachen, vorsieht

– die Platten (5) derart auszubilden, daß die Ecken (20) der Gießform (10) freigelassen werden, und

– den Kern (4) des Stempels derart in Richtung auf die Ecken zu verlängern, um Eckvorsprünge (19) vorzusehen, zwischen denen sich die Platten (5) einlagern können.

2. Verfahren nach Anspruch 1, dadurch gekennzeichnet, daß man vorsieht, in den Ecken (20) der Form (10) zwischen den Seitenwänden (20a) der Hohlkontur der Matrize (2) und den Seitenwänden (19') gegenüber dem Stempelkern (4) Füße (21) anzuordnen, die von den Wänden (20a, 19') der Matrize und dem Kern leicht abgesetzt sind, wobei die Füße im Schnitt die Form eines Winkels haben, dessen Öffnung gegen die Seitenwände (19') gerichtet ist.

3. Vorrichtung zur Durchführung des Formverfahrens nach Anspruch 1 oder Anspruch 2 der Bauart, die eine Form (10), umfassend eine äußere Matrize (2) mit einer Hohlkontur (2a) und einen inneren Stempel (3) aus mehreren Blöcken, umfaßt, die einen zentralen Stempelkern (4) umfassen, der von mehreren seitlichen Platten (5) umgeben ist, wobei der Stempelkern (4) und jede der Platten (5) gegenüberliegende Seitenwände bilden, die die Gestalt komplementärer Rampen (9, 11) haben, die entsprechend Pyramidalachsen (30) geneigt sind, wobei die Vorrichtung dadurch gekennzeichnet ist, daß der der Stempel (3) mindestens zwei seitliche Platten (5) umfaßt, die einander gegenüberliegend angeordnet und während des Gießvorganges gegen das Innere des Stempelkerns (4) zwischen Eckvorsprüngen (19) des Kerns gelagert sind, die den letzteren seitlich gegen die Ecken (20) der Form verlängern.

4. Vorrichtung nach Anspruch 3, dadurch gekennzeichnet, daß die Platten (5) die Gestalt eines "T" mit einem "T"-Schaft (5') aufweisen, der im wesentlichen gegen den zentralen Teil (4') des Kernstempels (4) gerichtet ist.

5. Vorrichtung nach Anspruch 3 oder 4, dadurch gekennzeichnet, daß der Kern (3) vier seitliche Platten umfaßt, die sich jeweils paarweise gegenüberliegen.

6. Vorrichtung nach einem der Ansprüche 3 bis 5, dadurch gekennzeichnet, daß die rampenförmige Seitenwand (11) jeder Platte (5) durch eine Führungsstange (12) verlängert ist, die der Form der Rampe (9) in bezug auf den Kern (4) angepaßt ist, wobei sich die Stangen (12) in ein darunter liegendes Formgestell (6) erstrecken können, und zwar durch Gleitführungsbohrungen (13) hindurch, die in einer Stempel-Halteplatte (7) ausgebildet sind, die zu dem oberen Teil des Gestells (6) hin angeordnet ist und den Kern (4) während des Gieß- bzw. Formvorganges des Gehäuses (50) trägt.

7. Vorrichtung nach Anspruch 6, dadurch gekennzeichnet, daß die Führungsstangen (12) auf derselben Auswerferplatte (14) befestigt sind, die gegen das Innere des Gestells (6) unterhalb der Stempel-Halteplatte (7) gelagert ist, wobei diese Platte translatorisch bewegbar ist, und zwar gemäß einer im wesentlichen in der Mitte zwischen den Pyramidalachsen (30) befindlichen vertikalen Achse (16).

8. Vorrichtung nach einem der Ansprüche 3 bis 7, dadurch gekennzeichnet, daß in den Ecken der Form gegenüber den Vorsprüngen (19) des Kerns (4) Füße (21) ausgebildet sind, wobei jeder der Füße leicht zu den Seitenwänden (19') in bezug auf den entsprechenden Vorsprung beabstandet ist und die Form eines Winkels mit gegen diesen Vorsprung gerichteter Öffnung aufweist.

9. Vorrichtung nach Anspruch 8, dadurch gekennzeichnet, daß die Füße (21) mechanisch mit dem Kern (4) verbunden sind und mit diesem im wesentlichen in einer Ebene zu liegen kommen.

10. Vorrichtung nach einem der Ansprüche 3 bis 9, dadurch gekennzeichnet, daß Ausschnitte (23), die jeder in Form einer Doppelnut gebildet sind, paarweise einander gegenüberliegend entlang wenigstens eines Teils der Höhe der beiden den Vorsprüngen (19) gegenübergelegenen Seitenwänden (19') vorgesehen sind.

11. Durch Ausübung des Verfahrens nach den Ansprüchen 1 oder 2 oder mittels der Vorrichtung gemäß einem der Ansprüche 3 bis 10 erhaltenes Gehäuse der Art, die umfaßt:
– Einen Innenraum, insbesondere vorgesehen für die Unterbringung von elektrischen Ausrüstungen und versehen mit einem Boden (33), in dessen Ecken Kammern (26) angeordnet sind, wobei diese durch Innenwände (28), die sie von dem Innenraum des Gehäuses trennen, und durch Außenwände (27) in gegenüberliegender Postition begrenzt und diese Kammern selbst mit einem Boden versehen sind,
– und Befestigungsmittel, um das Gehäuse mit einem Halter zu verbinden, dadurch gekennzeichnet, daß der Boden der Kammern (26) und derjenige (33) des Innenraums des Gehäuses auf der gleichen Seite geformt sind derart, daß sich die Kammern (26) nach außen zu der gleichen Seite hin wie der Innenraum öffnen, und daß die Mittel zur Befestigung des Gehäuses an seinem Halter in den Kammern (26) vorgesehen sind, wodurch diese Mittel außerhalb des Innenraums des Gehäuses angeordnet werden können.

12. Gehäuse nach Anspruch 11, dadurch gekennzeichnet, daß es eine doppelte Einfassung umfaßt, die durch die inneren (28) bzw. die äußeren (27) Seitenwände definiert ist, wobei die letzteren an wenigstens bestimmten Seiten des Gehäuses zwischen zwei aufeinanderfolgenden winkelförmigen Kammern (26) durch Materialbrücken bildende Rippen (31) miteinander verbunden sind.

13. Gehäuse nach Anspruch 11 oder 12, dadurch gekennzeichnet, daß die Materialbrücken (31) aus einer Hohlformung (bei 29) eines Teils der Innenwände (28) des Gehäuses hervorgehen.

14. Gehäuse nach einem der Ansprüche 11 bis 13, dadurch gekennzeichnet, daß die Materialbrücken (31) an ihrem Ende nahe dem freien Rand des Gehäuses entgegengesetzt zum Boden (33) die Form einer doppelstufigen Treppe aufweisen.

15. Gehäuse nach einem der Ansprüche 11 bis 14, dadurch gekennzeichnet, daß es eine Tür (60) umfaßt, die schwenkbar in wenigstens einem Scharnier (61, 62) gelagert ist, das an einem Rand an der Seite des Gehäuses vorgesehen ist, wobei die Tür (60) die Öffnung des Gehäuses in der Schließposition völlig abdeckt und die Öffnung durch die Außenwände (27) des Gehäuses begrenzt ist, sowie eine Türdichtung (63) enthält, die in der Schließstellung der Tür auf dem freien Rand gegenüber jeder Materialbrücke (31) im Kontakt mit den Innenwänden (28) aufgenommen wird, und zwar derart, daß die Isolation des inneren Teils des Gehäuses gewährleistet ist.

16. Gehäuse nach Anspruch 15, dadurch gekennzeichnet, daß die Tür (60) an ihrer Außenfläche (64) ein Flexurblatt (65) umfaßt, das im wesentlichen entlang der Achse (66) des Scharniers derart ausgebildet ist, daß eine Öffnung der Tür (60) bis zu einem im wesentlichen flachen Winkel möglich ist.

17. Gehäuse nach einem der Ansprüche 11 bis 16, dadurch gekennzeichnet, daß es Gleitschienen (34) mit Anschlägen (35) umfaßt, wobei die Gleitschienen jeweils paarweise einander gegenüberliegend auf der Innenfläche (28') der Innenwände (28) durch Gießen ausgebildet sind und sich von dem Boden (33) des Gehäuses bis etwa zur Hälfte der Tiefe desselben erstrecken.

18. Gehäuse nach einem der Ansprüche 11 bis 17,

18. Gehäuse nach einem der Ansprüche 11 bis 17, dadurch gekennzeichnet, daß die Höhe der Innenwände (28) des Gehäuses ein wenig größer ist als die Höhe seiner Außenwände (27).

**Claims**

1. A method of producing cases, cabinets or cupboards by moulding and of the type in which
— after having moulded the said casing (50) in one piece between the hollow cavity (2a) in an outer matrix (2) and an inner die (3) of a mould (10), the said die consisting of a plurality of blocks comprising a central core (4) surrounded by a plurality of lateral blocks (5),
— and after having opened the said mould (10) by moving the matrix (2) away from the die (3),
— the said core (4) and the said blocks (5) are separated and the same blocks (5) are removed from the walls of the casing (50) by withdrawing them in a relative bringing together movement directed in accordance with pyramidal axes (30) which converge in the direction of separation of the blocks, the said method being characterised in that in order to contain and guide the moulding pressure stresses into the corners (20) of the mould and to facilitate the operations of stripping the mould from the casing, it is envisaged that:
— the blocks (5) should be so shaped as to leave free the said corners (20) of the mould (10) and
— the core (4) of the die should be extended towards these said corners in such a way as to provide corner steps (19) between which the said blocks (5) can be accommodated.

2. A method according to Claim 1, characterised in that it is envisaged to dispose in the said corners (20) of the mould, between the lateral walls (12a) of the cavity in the matrix (2) and lateral walls (19') opposite the core (4) of the die, feet (21) which are slightly removed from the said walls (20a, 19') of the matrix and of the core, the said feet having in cross-section the form of an angle, the opening of which is directed towards the said lateral walls (19').

3. An apparatus for carrying out the moulding method according to Claim 1 or Claim 2, of the type comprising a mould (10) comprising an outer matrix (2) with a hollow cavity (2a) and an inner die consisting of a plurality of blocks comprising a central core (4) of a die surrounded by a plurality of lateral blocks (5), the die core (4) and each of the blocks (5) having lateral facing walls in the shape of complementary ramps (9, 11) inclined according to pyramidal axes (30), the said apparatus being characterised in that the die (3) comprises at least two lateral blocks (5) disposed face to face and, during the moulding operation, housed towards the interior of the die core (4), between corner steps (19) of the core which laterally extend the latter towards the corners (20) of the mould.

4. An apparatus according to Claim 3, characterised in that the blocks (5) take the form of a "T" with the leg (5') of the "T" directed substantially towards the central part (4') of the core (4) of the die.

5. An apparatus according to Claim 3 or Claim 4, characterised in that the core (3) comprises four lateral blocks which face each other in pairs.

6. An apparatus according to one of Claims 3 to 5, characterised in that the lateral ramp-like wall (11) of each of the blocks (5) is extended by a guide rod (12) which matches the shape of the ramp (9) facing the core (4), the said rods (12) being capable of extending into a subjacent mould frame (6), through sliding guide orifices (13) formed in a die holder (7) which is disposed towards the upper part of the frame (6) and supports the core (4) throughout the operation of moulding the casing (50).

7. An apparatus according to Claim 6, characterised in that the guide rods (12) are mounted on one and the same ejection plate (14) housed towards the interior of the frame (6) under the said die holder (7), the said plate being adapted for a translatory movement according to a vertical axis (16) substantially midway between the pyramidal axes (30).

8. An apparatus according to any one of Claims 3 to 7, characterised in that feet (21) are formed in the corners of the mould opposite the steps (19) of the core (4), each of the said feet being slightly removed from the lateral walls (19') facing the corresponding step and taking the form of an angled member with the opening directed towards the step.

9. An apparatus according to Claim 8, characterised in that the feet (21) are connected mechanically to the core (4) and are substantially level with it.

10. An apparatus according to any one of Claims 3 to 9, characterised in that notches (23), each taking the form of a double groove, are provided in pairs and opposite each other along at least a part of the height of two opposite lateral walls (19') of the steps (19).

11. A casing obtained by applying the method according to Claim 1 or Claim 2 or by means of the apparatus according to any one of Claims 3 to 10, of the type comprising:
— an interior space provided especially for the housing of electrical equipment and provided with a bottom (33) in the corners of which are chambers (26) which are bounded by interior walls (28) which separate them from the interior space in the casing and by outer walls (27) disposed opposite them, these chambers being themselves fitted with a bottom,
— and fixing means for connecting the casing to a support, characterised in that the bottom of the chambers (26) and that (33) of the inner space of the casing are formed on one and the same side in such a way that the chambers (26) open towards the outside on the same side as the said inner space, and in that the means of fixing the casing on its support are provided in the chambers (26) so making it possible to remove the said means to outside the interior space of the casing.

12. A casing according to Claim 11, characterised in that it comprises a double enclosure defined by the respectively outer (27) and inner (28) lateral walls, the latter being connected inter se on at least some of the sides of the casing, between two successive corner chambers (26), by ribs (31) which form bridges of material.

13. A casing according to Claim 11 or Claim 12 characterised in that the bridges (31) of material result from the recessing (at 29) of a part of the inner lateral walls (28) of the casing.

4. A casing according to any one of Claims 11 to 13, characterised in that the bridges (31) of material are, at their end which is close to the free edge of the casing opposite the bottom (33), shaped like a two-tread staircase.

15. A casing according to any one of Claims 11 to 14, characterised in that it comprises a door (60) mounted to pivot on at least one hinge (61, 62) provided on one side of the casing, the said door (60), when in the closed position, entirely covering the opening of the casing which is defined by the outer walls (27) of this latter and comprising a sealing tight gasket (63) which in the closed position of the door is received on the free edge opposite each of the said bridges of material (31), in contact with the inner walls (28), in order to insulate the interior of the casing.

16. A casing according to Claim 15, characterised in that, on its outer surface (64), the door (60) comprises a cranked portion (65) formed substantially along the axis (66) of the hinge in order to allow the door (60) to open substantially to a flat angle.

17. A casing according to any one of Claims 11 to 16, characterised in that it comprises slides (34) with integral abutments (35), the said slides being formed by moulding, in facing pairs, on the inside surface (28') of interior walls (28) and extending from the bottom (33) of the casing over substantially half the depth of this latter.

18. A casing according to any one of Claims 11 to 17, characterised in that the height of the inner walls (28) of the casing is slightly greater than the height of its outer walls (27).

FIG.1

FIG.2

FIG_4

FIG_3

FIG_5

FIG_6

EP 0 251 878 B1

FIG.7

FIG.8

FIG.9

FIG.10